Europäisches Patentamt

European Patent Office

Office européen des brevets

(19)

(11) **EP 0 606 453 B1**

(12) **FASCICULE DE BREVET EUROPEEN**

(45) Date de publication et mention
de la délivrance du brevet:
**04.06.1997 Bulletin 1997/23**

(21) Numéro de dépôt: **93917648.3**

(22) Date de dépôt: **24.07.1993**

(51) Int Cl.[6]: **H01L 31/0236**, H01L 31/0352

(86) Numéro de dépôt international:
**PCT/EP93/01980**

**WO 94/03930 (17.02.1994 Gazette 1994/05)**

(54) **CELLULE PHOTOVOLTAIQUE**

PHOTOVOLTAISCHE ZELLE

PHOTOVOLTAIC CELL

(84) Etats contractants désignés:
**CH DE ES FR GB IT LI NL**

(30) Priorité: **29.07.1992 FR 9209507**

(43) Date de publication de la demande:
**20.07.1994 Bulletin 1994/29**

(73) Titulaire: **ASULAB S.A.**
**CH-2501 Bienne (CH)**

(72) Inventeurs:
• **SAURER, Eric**
**CH-2022 Bevaix (CH)**
• **GRAETZEL, Michael**
**CH-1025 St-Sulpice (CH)**
• **MEYER, Tobias**
**CH-1173 Féchy (CH)**

(74) Mandataire: **de Montmollin, Henri et al**
**ICB**
**Ingénieurs Conseils en Brevets SA**
**Rue des Sors 7**
**2074 Marin (CH)**

(56) Documents cités:
**EP-A- 0 102 204          US-A- 4 851 658**

• **TECHNICAL DIGEST OF THE INTERNATIONAL PVSEC-5, 26 novembre 1990, Kyoto, JP, pp. 701-704; R. HEZEL et al.: 'Advantages of textured multicrystalline silicon for MIS inversion layer solar cells'**
• **PATENT ABSTRACTS OF JAPAN, vol. 12, no. 118 (E-600) 13 avril 1988; & JP-A-62 247 574**
• **PATENT ABSTRACTS OF JAPAN, vol. 10, no. 39 (E-381) 15 février 1986; & JP-A-60 195 979**
• **PATENT ABSTRACTS OF JAPAN, vol. 12, no. 49 (E-582) 13 février 1988; & JP-A-62 198 169**

## Description

L'invention concerne une cellule photovoltaïque et plus particulièrement une telle cellule comprenant une jonction présentant un facteur de rugosité élevé.

La transformation de l'énergie lumineuse en énergie électrique à l'aide de cellules photovoltaïques est connue de longue date et ces cellules sont actuellement utilisées dans différents dispositifs électroniques tels que des montres, des calculatrices, des appareils photo ou analogues.

Ces cellules peuvent se classer en quatre grandes familles, à savoir les cellules à jonction métal-semiconducteur (MS) de type diode Schottky, les cellules à jonction métal-isolant-semiconducteur (MIS), les cellules à jonction semiconducteur-isolant-semiconducteur (SIS), et les cellules à homojonction ou à hétérojonction.

On comprendra par jonction la zone de transition entre un métal et un semiconducteur ou entre deux semiconducteurs de types de conductivité différents.

Dans les cellules photovoltaïques en couches minces classiques, le matériau semiconducteur utilisé est déposé sous forme d'une mince couche continue et lisse à la surface d'un substrat recouvert préalablement d'une première électrode transparente réalisée par exemple en métal. Cette couche de matériau semiconducteur est ensuite recouverte selon le type de cellules d'une ou plusieurs couches (semiconductrice et/ou isolante et/ou conductrice), la couche supérieure formant la deuxième électrode.

Bien qu'au cours de ces dernières années des développements et des améliorations aient été apportés à ce genre de cellules pour augmenter leur rendement, ce dernier reste toujours relativement modeste.

Par ailleurs, la fabrication de ces cellules nécessite la mise en oeuvre de matériaux présentant une grande pureté et donc l'utilisation d'équipements sophistiqués disposés dans des salles blanches, si bien que ces cellules restent encore délicates à produire.

Pour remédier au moins en partie à ces inconvénients, la demande de brevet européen EP-A-0 102 204 suggère d'augmenter la surface de la jonction active de ces cellules en rendant cette jonction irrégulière, plus précisément rugueuse, de façon à ce qu'elle présente une surface développée supérieure à sa surface projetée.

Grâce à cette rugosité de la jonction, on augmente grandement l'efficacité de collection des photons incidents par rapport aux cellules classiques dans lesquelles la surface de la jonction est lisse. Cette augmentation est essentiellement due à la diffusion multiple de la lumière dans la couche de semiconducteur en association avec la plus grande surface de la jonction active. Il résulte donc de la structure de la cellule un rendement par unité de surface amélioré.

D'autre part, la demande de brevet européen en question suggère également trois solutions pour réaliser une cellule photovoltaïque en couches minces dont la jonction active est rugueuse.

Ces trois modes de réalisation permettent d'obtenir un facteur de rugosité de la jonction active, c'est-à-dire un rapport entre la surface réelle et la surface projetée de cette jonction, de l'ordre de 100.

Le but de l'invention est de fournir deux autres modes de réalisation grâce auxquels il est possible d'avoir un facteur de rugosité de la jonction beaucoup plus élevé et, par conséquent, un rendement très supérieur de la cellule.

Dans les deux cas, la cellule photovoltaïque comprend un substrat qui comporte une face de support sur laquelle s'étend une première électrode, et une deuxième électrode séparée de la première par une pluralité de couches comportant au moins une première couche d'un matériau semiconducteur à une interface de laquelle se trouve une jonction active qui présente une surface développée supérieure à sa surface projetée.

Dans l'un des deux modes de réalisation de la cellule selon l'invention, la première électrode comprend une couche uniforme formée d'un matériau conducteur et une couche poreuse formée de particules colloïdales conductrices qui présente une surface développée supérieure à sa surface projetée et au-dessus de laquelle s'étendent successivement lesdites couches et la deuxième électrode. De plus, dans ce mode de réalisation, la première couche de matériau semiconducteur a une épaisseur inférieure ou égale à la moitié de la largeur des pores de la couche poreuse.

Dans l'autre mode de réalisation de la cellule selon l'invention, la première couche de matériau semi-conducteur comprend une couche poreuse formée de particules colloïdales qui présente une surface développée supérieure à sa surface projetée et une couche uniforme recouvrant la couche poreuse, sur laquelle s'étendent successivement les autres couches et la deuxième électrode, les particules colloïdales ayant un diamètre inférieur à la longueur de diffusion des porteurs minoritaires créés dans la couche poreuse par absorption de lumière.

Dans les deux modes de réalisation, la couche de particules colloïdales confère à la jonction active une surface effective très élevée et donc un rapport surface effective/surface projetée également très élevé qui peut atteindre une valeur de l'ordre de 2000.

Cette couche permet en outre aux porteurs minoritaires produits en son sein par les photons incidents d'atteindre la jonction avant qu'une recombinaison de ces porteurs ne se produise et par conséquent de réaliser une cellule photovoltaïque qui tire au mieux partie de l'énergie fournie par les photons de la lumière incidente.

L'invention sera mieux comprise à la lecture de la description qui suit et qui se réfère aux dessins annexés parmi lesquels:

- la figure 1 représente schématiquement et en coupe un premier type de cellule photovoltaïque connu;

- les figures 2 à 4 sont respectivement des vues partielles agrandies de la cellule de la figure 1;
- les figures 5 et 6 sont des vues semblables à celles des figures 2 à 4 qui montrent les deux formes de réalisation de la même cellule selon l'invention;
- la figure 7 représente schématiquement et en coupe un deuxième type de cellule photovoltaïque connu;
- les figures 8 à 10 sont des vues partielles agrandies de la cellule de la figure 7; et
- les figures 11 et 12 montrent deux formes de réalisation du deuxième type de cellules selon l'invention.

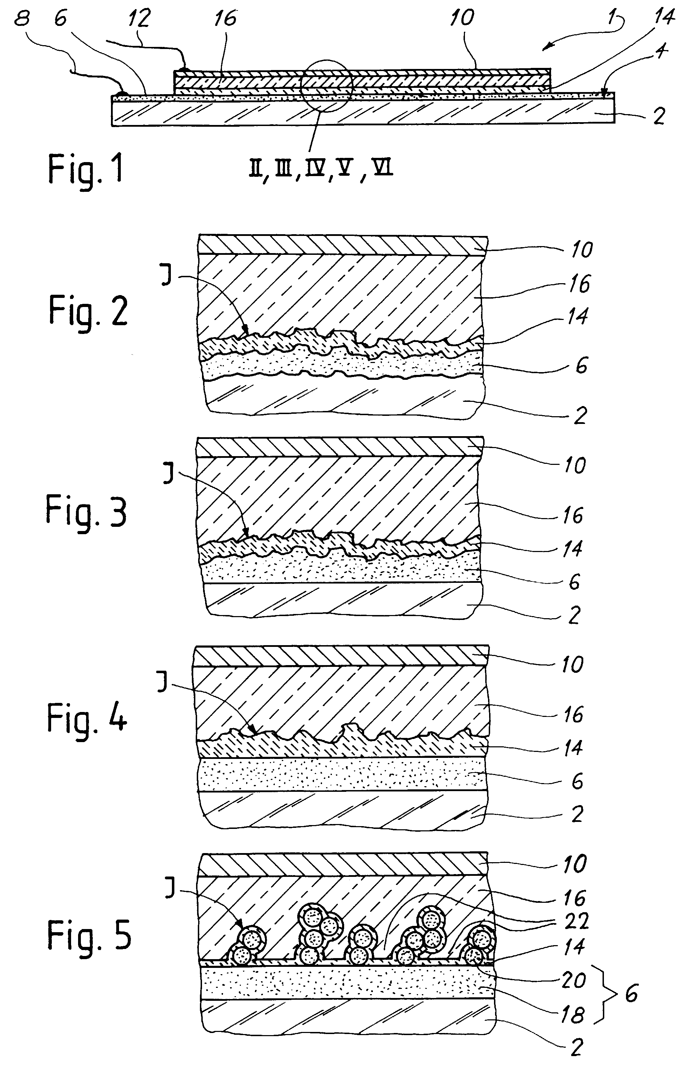

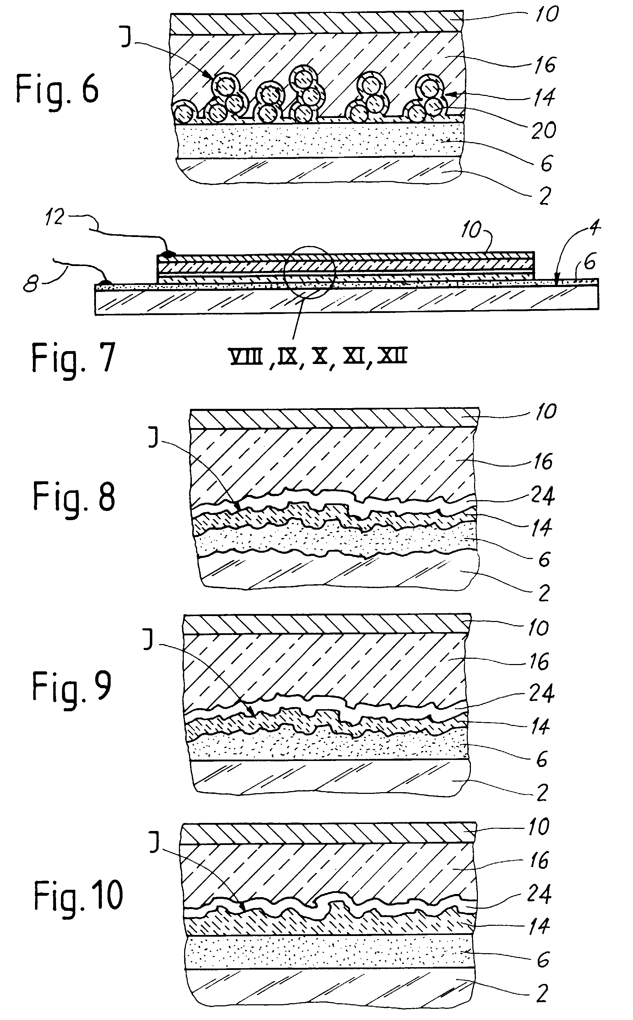

La cellule de la figure 1 peut être à jonction métal-semiconducteur de type Schottky (MS) ou à hétérojonction ou homojonction semiconducteur-semiconducteur. En ce qui concerne la cellule de la figure 7, il peut s'agir d'une cellule à jonction métal-isolant-semiconducteur (MIS) ou à jonction semiconducteur-isolant-semiconducteur (SIS).

Le principe de fonctionnement de ces grandes familles de cellules photovoltaïques est bien connu de l'homme du métier si bien qu'il n'y sera fait allusion dans la description qui suit que dans la mesure où il existe un lien entre ce principe et l'invention. Pour une explication des phénomènes physiques mis en jeu dans les cellules photovoltaïques, on pourra notamment se référer à l'ouvrage intitulé "Microelectronic Devices" par M. Edward S. Yang.

En se référant tout d'abord à la figure 1, on voit un premier type de cellule photovoltaïque désignée par la référence générale 1.

La cellule photovoltaïque 1 comprend un substrat 2 comportant sur la totalité de la surface d'une de ses grandes faces 4, dite face de support, une première électrode 6 reliée à un premier conducteur 8. La cellule 1 comprend une deuxième électrode 10 reliée à un deuxième conducteur 12, isolée de la première électrode 6 par une première couche 14 d'un matériau semiconducteur et une couche 16 d'un autre matériau. Selon le type de cellule photovoltaïque envisagé et comme cela apparaîtra dans la suite de la description, le matériau de cette couche 16 peut être soit un conducteur électronique (cellule MS) soit un semiconducteur (cellule de type à homojonction ou hétérojonction). Cette couche sera désignée ci-après comme couche conductrice ou deuxième couche de matériau semiconducteur selon le type de cellule qui sera décrit.

Bien entendu, on entend également par couche conductrice électronique une couche réalisée en matériaux organiques conducteurs électroniques et on entend par matériaux semiconducteurs aussi bien les matériaux semiconducteurs inorganiques que les semiconducteurs organiques.

La première couche 14 de matériau semiconducteur est directement en contact avec la première électrode 6 et réalise avec la couche 16 une jonction active désignée par J dans les figures 2 à 6.

La première électrode 6 peut être réalisée avantageusement sous la forme d'une couche mince d'une épaisseur de l'ordre de 10 à 500 nanomètres et en un matériau choisi parmi l'ensemble comprenant l'oxyde d'étain dopé au fluor, à l'antimoine ou à l'arsenic, l'oxyde d'indium dopé à l'oxyde d'étain, le stannate d'aluminium, et l'oxyde de zinc dopé à l'aluminium.

Bien entendu, l'homme de métier peut choisir tout autre couche conductrice électronique transparente équivalente.

La nature de la deuxième électrode 10 dépend de la nature de la couche 16 et peut dans le cas où cette dernière est électriquement conductrice être omise. Dans le cas où la couche 16 n'est pas conductrice, la deuxième électrode 10 peut être réalisée avantageusement sous la forme d'une couche mince d'un matériau tel que l'or ou l'aluminium ou d'un matériau présentant des propriétés de conductivité électrique analogues.

Bien entendu, soit le substrat 2 et la première électrode, soit la deuxième électrode 10 sont transparentes aux photons du domaine spectral considéré.

On notera que le dessin ne reflète pas les dimensions exactes de la cellule ainsi formée, ces dimensions ayant été fortement exagérées pour des raison de clarté.

Dans la première des trois formes de réalisation connues, qui est représentée à la figure 2, la face de support 4 du substrat 2 présente une surface développée supérieure à sa surface projetée. Les couches suivantes qui s'étendent successivement sur le substrat 2 épousent étroitement la configuration en relief de la face de support 4 de sorte que la structuration de la face 4 du substrat 2 a pour effet que la jonction active J a une surface développée supérieure à sa surface projetée.

La couche formant l'électrode 6 ainsi que la première couche 14 ont une épaisseur telle que la surface développée de la jonction active J soit sensiblement équivalente à celle de la face de support 4 du substrat.

De préférence, la face de support 4 présente un facteur de rugosité supérieur à 20 et typiquement un facteur de rugosité de l'ordre de 100, ce qui permet d'obtenir une cellule présentant une efficacité de collection de la lumière par diffusion multiple de la lumière relativement grande par rapport aux cellules classiques.

Le facteur de rugosité approprié de cette face de support 4 peut-être obtenu de manière simple, par exemple, par abrasion ou encore par une attaque chimique. Dans le cas où le substrat 2 est réalisé en un matériau organique, le facteur de rugosité de la face de support peut être, par exemple obtenu par moulage.

Les autres couches sont déposées successivement de façon classique par exemple par dépôt chimique en phase vapeur ou par dépôt physique sous vide.

Selon la forme de réalisation représentée à la figure 3, la surface de support 4 est lisse et c'est la face de la première électrode 6 opposée à cette face 4 qui a un aspect rugueux. Les autres couches, en particulier la première couche 14 de matériau semiconducteur, s'étendent successivement sur la première électrode 6 et épousent étroitement son relief. Là encore, le facteur de rugosité est supérieur à 20 et typiquement de l'ordre de 100.

Pour obtenir ce facteur de rugosité, la première électrode 6 peut-être par exemple déposée par évaporation tangentielle sous vide (le substrat étant incliné de 3° à 20° par rapport à la direction d'évaporation), les autres couches étant déposées classiquement comme cela a déjà été indiqué ci-dessus.

Selon la troisième forme de réalisation connue, qui est représentée à la figure 4, la face de support 4 du substrat 2 et la première électrode 6 ne présentent pas de facteur de rugosité particulière mais la face de la première couche 14 de matériau semiconducteur qui est en contact avec la couche 16, c'est-à-dire la jonction active J est rugueuse et présente un facteur de rugosité supérieur à 20 et de préférence de l'ordre de 100.

Dans ce cas, la première couche 14 de matériau semiconducteur peut être par exemple déposée par évaporation tangentielle sous vide.

En se référant à la figure 5 ,on voit une première forme de réalisation de la cellule selon l'invention dans laquelle la première électrode 6 comprend une couche uniforme 18 formée d'un matériau conducteur, tel que ceux décrits plus haut, sur laquelle est déposée, par exemple par un procédé sol-gel, une couche de particules colloïdales 20 d'un même matériau. Les couches suivantes sont déposées successivement sur l'électrode 6 comme décrit ci-dessus.

La couche 18 présente typiquement une épaisseur comprise dans une gamme s'étendant de 15 à 150 nanomètres et les particules colloïdales 20 présentent, de préférence, un diamètre de 1 à 200 nanomètres. Ces particules sont agglomérées et forment à la surface du substrat 2 une couche poreuse dont l'épaisseur est comprise entre 0,1 et 20 micromètres.

Ceci conduit donc à réaliser une première couche 14 de matériau semiconducteur et donc une jonction active présentant un rapport surface active/surface projetée de l'ordre de 2000, et par conséquent une cellule dont la surface active est très élevée.

Pour que cette forme d'exécution offre un maximum d'efficacité, on veillera à ce que la première couche 14 de matériau semiconducteur ait une épaisseur inférieure ou égale à la moitié de la largeur des pores 22 formés par les particules 20 à défaut de quoi les pores 22 se bouchent ce qui diminue considérablement le facteur de rugosité de la jonction active J.

Selon la deuxième forme de réalisation de la cellule selon l'invention, qui est représentée à la figure 6, la face de support 4 du substrat 2 et la première électrode 6 ne présentent pas de rugosité particulière mais, la première couche 14 de matériau semiconducteur comprend une couche poreuse, formée de particules colloïdales 20, et une couche lisse sur laquelle sont déposées les couches suivantes.

Dans ce cas, la taille des particules 20 et l'épaisseur de la couche formée par les particules ont une incidence importante sur la réponse de la cellule à l'excitation par la lumière incidente.

En effet, les particules de la couche absorbent les photons dont l'énergie est égale ou dépasse la différence d'énergie entre la bande de conduction et la bande de valence du matériau des particules. Cette absorption de lumière entraîne la création de paires électrons-trous dans les particules. Avec par exemple une couche 14 réalisée en un matériau semiconducteur tel que le $TiO_2$ de type n, les électrons sont les porteurs majoritaires alors que les trous sont les porteurs minoritaires. Or, lorsqu'une telle cellule à jonction semiconducteur/métal, respectivement semiconducteur /semiconducteur, est utilisée pour créer de l'électricité à partir de la lumière absorbée, il est nécessaire que les trous puissent diffuser jusqu'à cette jonction avant que leur recombinaison avec les électrons puisse se produire. En d'autres termes, la longueur de diffusion des porteurs minoritaires désignée par $l_{pm}$, doit être plus grande que la distance que ces porteurs doivent parcourir avant d'atteindre la jonction.

Cette longueur de diffusion est définie par

$$l_{pm} = (2D\tau)^{0,5}$$

dans laquelle $\tau$ est la durée de vie d'un trou et D est la constante de diffusion des porteurs minoritaires. A titre d'exemple la valeur de $l_{pm}$ est de 100 nanomètres pour le $TiO_2$.

Le diamètre des particules colloïdales 20 doit donc être inférieur à la longueur de diffusion des porteurs minoritaires pour que ces porteurs aient une grande probabilité d'atteindre la jonction semiconducteur/métal respectivement semiconducteur/ semiconducteur et pour obtenir ainsi une séparation efficace des porteurs de charge et un grand rendement de conversion.

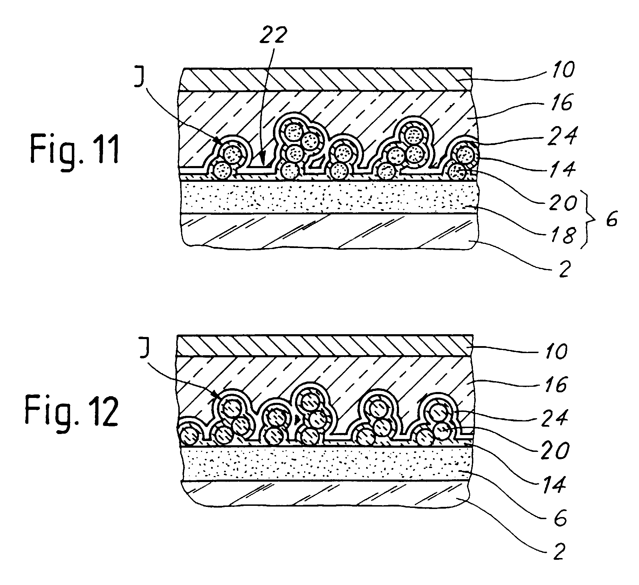

En se référant maintenant aux figures 7 à 12, on voit différentes formes de réalisation connues (figures 7 à 10) et selon l'invention (figures 11 et 12) de cellules photovoltaïques à jonction métal-isolant-semiconducteur (MIS) ou semiconducteur-isolant-semiconducteur (SIS) dans lesquelles les éléments identiques à ceux décrits en liaison avec les figures 1 à 6 sont désignés par les mêmes références numériques.

Comme cela ressort clairement des figures 7 à 12, la structure de ces cellules photovoltaïques ne se distingue des cellules décrites en liaison avec les figures 1 à 6 que par le fait qu'une couche 24 d'un matériau isolant s'étend entre la première couche 14 de matériau semiconducteur et les couches 16 et 10 se trouvant au-dessus de celle-ci, quelle que soit la nature de ces couches 16 et 10.

La couche 24 de matériau isolant présente avantageusement une épaisseur comprise entre un 1 et 50 nanomètres. Dans tous les cas, l'épaisseur de cette couche doit permettre l'injection par effet tunnel d'électrons de la première couche 14 de matériau semiconducteur dans la couche 16 formant la deuxième couche de matériau semiconducteur, dans le cas d'une cellule SIS ou dans la couche de métal, dans le cas d'une cellule MIS.

La première couche 14 de matériau semiconducteur peut-être réalisée en un matériau semiconducteur minéral. Il est de même la couche 16 dans le cas d'une cellule SIS.

Toutefois, dans le cas de la forme de réalisation de la cellule selon l'invention représentée à la figure 11, on veillera, comme dans celle représentée à la figure 5, à ce que la première couche 14 de matériau semiconducteur ait une épaisseur inférieure ou égale à la moitié de la dimension des pores 22 formés par les particules 20, à défaut de quoi ces pores 22 se bouchent ce qui diminue considérablement le facteur de rugosité.

Le matériau semiconducteur constituant les couches 14 (cellules MS, MIS, SIS, à homojonction et à hétérojonction) et/ou 16 (cellules SIS, à homojonction et à hétérojonction) qui viennent d'être décrites peut être choisi parmi l'ensemble des matériaux semiconducteurs compris dans les quatre groupes suivants.

Le premier groupe comprend les oxydes des éléments de transition, les oxydes des éléments des colonnes 13 et 14 de la classification périodique moderne, et les oxydes des lanthanides (cf. Cours de chimie physique de Paul Arnaud aux éditions Dunod 1988).

Le deuxième groupe comprend les oxydes mixtes formés d'un mélange de deux ou plusieurs des oxydes du premier groupe.

Le troisième groupe comprend les oxydes mixtes formés d'un mélange d'un ou de plusieurs oxydes du premier groupe avec des oxydes des éléments des colonnes 1 et 2 de la classification périodique moderne.

Le quatrième groupe est formé de l'ensemble des matériaux semiconducteurs comprenant:
le silicium, l'hydrure de silicium, le carbure de silicium, le germanium, le sulfure de cadmium, le tellurure de cadmium, le sulfure de zinc, le sulfure de plomb, le sulfure de fer, le sulfure de zinc et de cadmium, le séléniure de zinc, l'arséniure de gallium, le phosphorure d'indium, le phosphorure de gallium, le phosphorure de cadmium, le fluorure de titane, le nitrure de titane, le fluorure de zirconium, le nitrure de zirconium, le diamant dopé, le thiocyanate de cuivre, et les chalcopyrites purs et mixtes.

De préférence, ce matériau semiconducteur est choisi parmi l'ensemble des matériaux comprenant l'oxyde de titane, l'oxyde de lanthanium, l'oxyde de zirconium, l'oxyde de niobium, l'oxyde de tungstène, l'oxyde de strontium, l'oxyde calcium/titane, le titanate de sodium, et le niobate de potassium.

Les couches 14 et/ou 16 peuvent-être réalisées en un matériau semiconducteur organique.

Le matériau semiconducteur constituant ces couches 14 et/ou 16 peut être choisi parmi les matériaux semiconducteurs de l'ensemble comprenant les phtalocyanines (désignées ci-après par Pc), le 2,9-diméthyl 1 quinacridone, le 1,1-bis (4-di-$p$-tolylaminophényl) cyclohexane, la phtalocyaninebisnaphtalocyanine, le poly(N-vinylcarbazole), les polyanthracènes, les polyphénols, les polysilanes, le poly($p$-phénylène)vinylène, les porphyrines, le perylène et ses dérivés, le poly(benzo[C] thiophène) =poly(isothianaphtène), le polythiophène, poly(3-méthylthiophène), le poly(3-octylthiophène), la polyaniline, le poly($p$-phénylène), le poly(thiophène)vinylène, le polyacétylène, le polyazulène, et les diacéthylènes.

De préférence, ce matériau semiconducteur est choisi parmi l'ensemble des matériaux comprenant le $H_2Pc$, le MgPc dopé à l'$O_2$, le CuPc, le ZnPc, le FePc, le SiPc, le NiPc, le Al(Cl)Pc, le Al(OH)Pc, le $LuPc_2$ dopé au dichlorocyanoquinone, le dichlorure de tétra-4-terbutylphthalocyaninosilicium, le LuPc2:2,2' 6,6'-tétraphényl-4,4' ($p$-diméthylaminostyryl) -4H-pyrane et le 5,10,15,20-tétra(3-pyridyl)porphyrine, le LuPc et le Ni-Pc:$I_2$.

Il est bien entendu que ce matériau semiconducteur peut avoir un type de conductivité n ou p selon le type de cellule envisagé.

La couche 16 dans le cas des cellules MS ou MIS peut être réalisée en un matériau choisi dans l'ensemble des métaux comprenant le platine, le ruthénium, le rhodium, le palladium, l'iridium, l'osmium l'argent, l'or, le platine, l'aluminium, l'indium, le magnésium et les oxydes conducteurs des éléments des colonnes 8 à 10 de la classification périodique moderne.

Selon une variante cette couche 16 des cellules MS ou MIS peut être formée par un polymère conducteur choisi de façon avantageuse dans l'ensemble comprenant le poly(benzo[C]thiophène)=poly(isothianaphtène), le polythiophène, poly(3-méthylthiophène), le poly (3-octylthiophène), la polyaniline, le poly($p$-phénylène), le poly(thiophène)vinylène, le polyacétylène, le polyazulène, les diacéthylènes et les phtalocyanines dopés et non dopés.

Dans les cellules photovoltaïques à jonction métal-isolant-semiconducteur (MIS) ou semiconducteur -isolant-semiconducteur (SIS), la couche de matériau isolant 24 peut-être réalisée en un matériau choisi parmi l'ensemble comprenant l'oxyde d'aluminium, l'oxyde de silicium, l'oxyde de zirconium, l'oxyde d'yttrium, l'oxyde de lanthane, le fluoro-oxyde d'aluminium, le nitrure de bore cubique, le diamant, parmi l'ensemble des oxydes métalliques ayant une bande interdite supérieure à 3,5 eV ou parmi l'ensemble des polymères isolants comprenant le polyimide, le polymétaméthylacrylate, polyéthylène, polypropylène, le polystyrène, et les polysilanes.

On notera que l'on peut obtenir une cellule photovoltaïque transparente ou quasi transparente avec un choix judicieux des différents matériaux utilisés pour réaliser la cellule.

**Revendications**

1. Cellule photovoltaïque (1) comprenant un substrat (2) comportant une face de support (4) sur laquelle s'étend une première électrode (6), et une deuxième électrode (10) séparée de la première électrode (6) par une pluralité de couches (14, 16; 14, 24, 16) comportant au moins une première couche (14) d'un matériau semiconducteur à une interface de laquelle se trouve une jonction active (J) qui présente une surface développée supérieure à sa surface projetée, caractérisée en ce que ladite première électrode (6) comprend une couche uniforme (18) formée d'un matériau conducteur et une couche poreuse formée de particules colloïdales conductrices (20) qui présente une surface développée supérieure à sa surface projetée et au-dessus de laquelle s'étendent successivement lesdites couches (14, 16; 14, 24, 16) et ladite deuxième électrode (10), et en ce que ladite première couche (14) de matériau semiconducteur a une épaisseur inférieure ou égale à la moitié de la largeur des pores (22) de ladite couche poreuse.

2. Cellule selon la revendication 1, caractérisée en ce que ladite jonction active (J) présente un facteur de rugosité de l'ordre de 2000.

3. Cellule selon la revendication 1 ou 2, caractérisée en ce que lesdites particules colloïdales conductrices (20) ont un diamètre compris entre 1 et 200 nanomètres.

4. Cellule selon l'une quelconque des revendications 1 à 3, caractérisée en ce que ladite couche formée de particules colloïdales conductrices (20) présente une épaisseur comprise entre 0,1 et 20 micromètres

5. Cellule selon l'une quelconque des revendications précédentes, caractérisée en ce que ladite pluralité de couches (14, 16; 14, 24, 16) comprend, outre ladite première couche (14) de matériau semiconducteur, une couche conductrice (16) qui s'étend entre ladite première couche (14) de matériau semiconducteur et ladite deuxième électrode (10).

6. Cellule selon la revendication 5, caractérisée en ce que ladite pluralité de couches (14, 24, 16) comprend en outre une couche (24) de matériau isolant s'étendant entre ladite première couche (14) de matériau semiconducteur et ladite couche (16) conductrice.

7. Cellule selon la revendication 5 ou 6, caractérisée en ce que ladite deuxième électrode (10) est formée par ladite couche conductrice.

8. Cellule selon l'une quelconque des revendications 1 à 4, caractérisée en ce que ladite pluralité de couches (14, 16; 14, 24, 16) comprend, outre ladite première couche (14) de matériau semiconducteur, une deuxième couche (16) de matériau semiconducteur d'un type de conductivité différent de celui de la première couche (14) de matériau semiconducteur et qui s'étend entre ladite première couche et la deuxième électrode (10).

9. Cellule selon la revendication 8, caractérisée en ce que ladite pluralité de couches (14, 16; 14, 24, 16) comprend en outre une couche (24) de matériau isolant s'étendant entre ladite première couche (14) de matériau semiconducteur et ladite deuxième couche (16) de matériau semiconducteur.

10. Cellule selon l'une quelconque des revendications précédentes, caractérisée en ce que la première électrode (6) est réalisée en un matériau choisi parmi l'ensemble comprenant l'oxyde d'étain dopé au fluor,à l'antimoine ou à l'arsenic, le stannate d'aluminium, et l'oxyde de zinc dopé à l'aluminium.

11. Cellule selon l'une quelconque des revendications 1 à 10, caractérisée en ce que ladite première couche (14) de matériau semiconducteur est réalisée en un matériau semiconducteur inorganique.

12. Cellule selon la revendication 8 ou 9, caractérisée en ce que ladite première couche (14) de matériau semiconducteur et/ou ladite deuxième couche de matériau semiconducteur (16) sont réalisées en un matériau semiconducteur inorganique.

13. Cellule selon l'une quelconque des revendications 1 à 10, caractérisée en ce que ladite première couche (14) de matériau semiconducteur est réalisée en un matériau semiconducteur organique.

14. Cellule selon la revendication 8 ou 9, caractérisée en ce que ladite première couche (14) de matériau semiconducteur et/ou ladite deuxième couche de matériau semiconducteur (16) sont réalisées en un matériau semiconducteur organique.

15. Cellule selon la revendication 12, caractérisée en ce que ladite première couche (14) de matériau semiconducteur et/ou ladite deuxième couche de matériau semiconducteur (16) sont réalisées en un matériau semiconducteur, choisi dans l'ensemble des matériaux semiconducteurs formé d'un premier groupe comprenant les oxydes semiconducteurs des éléments de transition, les oxydes semiconducteurs des éléments des colonnes 13 et 14 de la classification périodique moderne, et les oxydes semiconducteurs des lanthanides, d'un deuxième groupe comprenant les oxydes mixtes semiconducteurs formés d'un mélange de deux ou de plusieurs oxydes du premier groupe, d'un troisième groupe comprenant les oxydes mixtes semiconducteurs formés d'un mélange d'un ou de plusieurs oxydes du premier groupe avec des oxydes des éléments des colonnes 1 et 2 de la classification périodique moderne et d'un quatrième groupe comprenant le silicium, l'hydrure de silicium, le carbure de silicium, le germanium, le sulfure de cadmium, le tellurure de cadmium, le sulfure de zinc, le sulfure de plomb, le sulfure de fer, le séléniure de zinc, l'arséniure de gallium, le phosphorure d'indium, le phosphorure de gallium, le phosphorure de cadmium, le fluorure de titane, le nitrure de titane, le fluorure de zirconium, le nitrure de zirconium, le diamant dopé, le thiocyanate de cuivre, et les chalcopyrites purs et mixtes.

16. Cellule selon la revendication 15, caractérisée en ce que le matériau semiconducteur est choisi parmi l'ensemble des matériaux comprenant l'oxyde de titane, l'oxyde de lanthanium, l'oxyde de zirconium, l'oxyde de niobium, l'oxyde de tungstène, l'oxyde de strontium, l'oxyde calcium/titane,le titanate de sodium, et le niobiate de potassium.

17. Cellule selon la revendication 14, caractérisé en ce que ladite première couche (14) de matériau semiconducteur et/ou ladite deuxième couche de matériau semiconducteur (16) sont réalisées en un matériau semiconducteur choisi parmi l'ensemble des matériaux semiconducteurs dopés et/ou non dopés comprenant les phtalocyanines, le 2,9-diméthyl quinacridone, le 1,1-bis (4-di-*p*-tolylaminophényl) cyclohexane, la phtalocyaninebisnaphtalocyanine, le poly(N-vinylcarbazole), les polyanthracènes, les polyphénols, les polysilanes, le poly(*p*-phénylène) vinylène, les porphyrines, le perylène et ses dérivés, le poly(benzo[C]thiophène) =poly(isothianaphtène), le polythiophène, poly(3-méthylthiophène), le poly(3-octylthiophène), la polyaniline, le poly(*p*-phénylène), le poly(thiophène)vinylène, le polyacétylène, le polyazulène, les diacéthylènes.

18. Cellule selon la revendication 14, caractérisée en ce que ladite première couche (14) de matériau semiconducteur et/ou ladite deuxième couche de matériau semiconducteur (16) sont réalisées en un matériau semiconducteur choisi parmi l'ensemble des matériaux semiconducteurs comprenant le $H_2Pc$, le MgPc dopé à l'$O_2$, le CuPc, le ZnPc, le FePc, le SiPc, le NiPc, le Al(Cl)Pc, le Al(OH)Pc, le $LuPc_2$ dopé au dichlorocyanoquinone, le dichlorure de tétra-4-ter- butylphthalocyaninosilicium, le LuPc2:2,2' 6,6'-tétraphenyl-4,4'(*p*-diméthylaminostyryl)4H-pyrane et le 5,10,15,20-tétra(3-pyridyl)porphyrine, le LuPc et le NiPc:$I_2$, l'abréviation $P_c$ signifiant phtalocyanine.

19. Cellule selon la revendication 5, caractérisée en ce que la couche conductrice (16) est réalisée en un matériau choisi dans l'ensemble formé d'un premier groupe comprenant le poly(benzo[C]thiophène) =poly (isothianaphtène) , le polythiophène, poly (3-méthylthiophène), le poly(3-octylthiophène), la polyaniline, le poly(*p*-phénylène), le poly(thiophène)vinylène, le polyacétylène, le polyazulène, les diacéthylènes et les phtalocyanines dopés ou non dopés et d'un deuxième groupe comprenant le platine, le ruthénium, le rhodium, le palladium, l'iridium, l'osmium l'argent, l'or, le platine, l'aluminium, l'indium, le magnesium et les oxydes conducteurs des éléments des colonnes 8 à 10 de la classification périodique moderne.

20. Cellule selon la revendication 6, caractérisée en ce que la couche (26) de matériau isolant est réalisée en un matériau choisi parmi l'ensemble formé d'un premier groupe comprenant l'oxyde d'aluminium, l'oxyde de silicium, l'oxyde de zirconium, l'oxyde d'yttrium, l'oxyde de lanthane, le fluoro-oxyde d'aluminium, le nitrure de bore cubique, le diamant, d'un deuxième groupe comprenant des oxydes métalliques ayant une bande interdite supérieure à 3,5 eV, et d'un troisième groupe comprenant le polyimide, le polymétaméthylacrylate, polyéthylène, polypropylène, le polystyrène, et les polysilanes.

21. Cellule photovoltaïque (1) comprenant un substrat (2) comportant une face de support (4) sur laquelle s'étend une première électrode (6), et une deuxième électrode (10) séparée de la première électrode (6) par une pluralité de couches (14, 16; 14, 24, 16) comportant au moins une première couche (14) d'un matériau semiconducteur à une interface de laquelle se trouve une jonction active (J) qui présente une surface développée supérieure à sa surface projetée, caractérisée en ce que ladite première couche (14) de matériau semiconducteur comprend une couche poreuse formée de particules colloïdales (20) qui présente une surface développée supérieure à sa surface projetée et une couche uniforme recouvrant ladite couche poreuse, sur laquelle s'étendent successivement les autres couches (16; 24, 16) et ladite deuxième électrode (10), et en ce que lesdites particules colloïdales (20) ont un diamètre inférieur à la longueur de diffusion des porteurs minoritaires créés dans ladite couche poreuse par absorption de lumière.

22. Cellule selon la revendication 21, caractérisée en ce que ladite jonction active (J) présente un facteur de rugosité de l'ordre de 2000.

23. Cellule selon la revendication 21 ou 22, caractérisée en ce que lesdites particules colloïdales ont un diamètre compris entre 1 à 200 nanomètres.

**24.** Cellule selon l'une quelconque des revendications 21 à 23, caractérisée en ce que ladite couche formée de particules colloïdales (20) présente une épaisseur comprise entre 0,1 et 20 micromètres.

**25.** Cellule selon l'une quelconque des revendications 21 à 24, caractérisée en ce que ladite pluralité de couches (14, 16; 14, 24, 16) comprend, outre ladite première couche (14) de matériau semiconducteur, une couche conductrice (16) qui s'étend entre ladite première couche (14) de matériau semiconducteur et ladite deuxième électrode (10).

**26.** Cellule selon la revendication 25, caractérisée en ce que ladite pluralité de couches (14, 24, 16) comprend en outre une couche (24) de matériau isolant s'étendant entre ladite première couche (14) de matériau semiconducteur et ladite couche conductrice.

**27.** Cellule selon la revendication 25 ou 26, caractérisée en ce que ladite deuxième électrode (10) est formée par ladite couche conductrice.

**28.** Cellule selon l'une quelconque des revendications 21 à 24, caractérisée en ce que ladite pluralité de couches (14, 16; 14, 24, 16) comprend, outre ladite première couche (14) de matériau semiconducteur, une deuxième couche (16) de matériau semi-conducteur d'un type de conductivité différent de celui de la première couche (14) de matériau semiconducteur et qui s'étend entre ladite première couche et la deuxième électrode (10).

**29.** Cellule selon la revendication 28, caractérisée en ce que ladite pluralité de couches (14, 16; 14, 24, 16) comprend en outre une couche (24) de matériau isolant s'étendant entre ladite première couche (14) de matériau semiconducteur et ladite deuxième couche (16) de matériau semiconducteur.

**30.** Cellule selon l'une quelconque des revendications 21 à 29, caractérisée en ce que la première électrode (6) est réalisée en un matériau choisi parmi l'ensemble comprenant l'oxyde d'étain dopé au fluor, à l'antimoine ou à l'arsenic, le stannate d'aluminium, et l'oxyde de zinc dopé à l'aluminium.

**31.** Cellule selon l'une des revendications 21 à 30, caractérisée en ce que ladite première couche (14) de matériau semiconducteur est réalisée en un matériau semiconducteur inorganique.

**32.** Cellule selon la revendication 28 ou 29, caractérisée en ce que ladite première couche (14) de matériau semiconducteur et/ou ladite deuxième couche de matériau semiconducteur (16) sont réalisées en un matériau semiconducteur inorganique.

**33.** Cellule selon l'une quelconque des revendications 21 à 30, caractérisée en ce que ladite première couche (14) de matériau semiconducteur est réalisée en un matériau semiconducteur organique.

**34.** Cellule selon la revendication 28 ou 29, caractérisée en ce que ladite première couche (14) de matériau semiconducteur et/ou ladite deuxième couche de matériau semiconducteur (16) sont réalisées en un matériau semiconducteur organique.

**35.** Cellule selon la revendication 32, caractérisée en ce que ladite première couche (14) de matériau semiconducteur et/ou ladite deuxième couche de matériau semiconducteur (16) sont réalisées en un matériau semiconducteur, choisi dans l'ensemble des matériaux semiconducteurs formé d'un premier groupe comprenant les oxydes semiconducteurs des éléments de transition, les oxydes semiconducteurs des éléments des colonnes 13 et 14 de la classification périodique moderne, et les oxydes semiconducteurs des lanthanides, d'un deuxième groupe comprenant les oxydes mixtes semiconducteurs formés d'un mélange de deux ou de plusieurs oxydes du premier groupe, d'un troisième groupe comprenant les oxydes mixtes semiconducteurs formés d'un mélange d'un ou de plusieurs oxydes du premier groupe avec des oxydes des éléments des colonnes 1 et 2 de la classification périodique moderne et d'un quatrième groupe comprenant le silicium, l'hydrure de silicium, le carbure de silicium, le germanium, le sulfure de cadmium, le tellurure de cadmium, le sulfure de zinc, le sulfure de plomb, le sulfure de fer, le séléniure de zinc, l'arséniure de gallium, le phosphorure d'indium, le phosphorure de gallium, le phosphorure de cadmium, le fluorure de titane, le nitrure de titane, le fluorure de zirconium, le nitrure de zirconium, le diamant dopé, le thiocyanate de cuivre, et les chalcopyrites purs et mixtes.

**36.** Cellule selon la revendication 35, caractérisée en ce que le matériau semiconducteur est choisi parmi l'ensemble des matériaux comprenant l'oxyde de titane, l'oxyde de lanthanium, l'oxyde de zirconium, l'oxyde de niobium, l'oxyde de tungstène, l'oxyde de strontium, l'oxyde calcium/titane, le titanate de sodium, et le niobiate de potassium.

**37.** Cellule selon la revendication 34, caractérisé en ce que ladite première couche (14) de matériau semiconducteur et/ou ladite deuxième couche de matériau semiconducteur (16) sont réalisées en un matériau semiconducteur choisi parmi l'ensemble des matériaux semiconducteurs dopés et/ou non dopés comprenant les phtalocyanines, le 2,9-diméthyl quinacridone, le 1,1-bis (4-di-$p$-tolylaminophényl) cyclohexane, la phtalocyaninebisnaphtalocyanine, le poly(N-vinylcarbazole), les polyanthracènes, les polyphénols, les polysilanes, le poly(*p*-phénylène) vinylène, les porphyrines, le perylène et ses dérivés, le poly(benzo[C]thiophène) =poly(isothianaphtène), le polythiophène, poly(3-méthylthiophène), le poly(3-octylthiophène), la polyaniline, le poly(*p*-phénylène), le poly(thiophène)vinylène, le polyacétylène, le polyazulène, les diacéthylènes.

38. Cellule selon la revendication 34, caractérisée en ce que ladite première couche (14) de matériau semiconducteur et/ou ladite deuxième couche de matériau semiconducteur (16) est réalisée en un matériau semiconducteur choisi parmi l'ensemble des matériaux semiconducteurs comprenant le $H_2Pc$, le MgPc dopé à l'$O_2$, le CuPc, le ZnPc, le FePc, le SiPc, le NiPc, le Al(Cl)Pc, le Al(OH)Pc, le $LuPc_2$ dopé au dichlorocyanoquinone, le dichlorure de tétra-4-ter- butylphthalocyaninosilicium, le LuPc2:2,2' 6,6'-tétraphenyl-4,4'(p-diméthylaminostyryl)4H-pyrane et le 5,10,15,20-tétra(3-pyridyl)porphyrine, le LuPc et le NiPc:$I_2$, l'abréviation $P_c$ signifiant phtalocyanine.

39. Cellule selon la revendication 25, caractérisée en ce que la couche conductrice (16) est réalisée en un matériau choisi dans l'ensemble formé d'un premier groupe comprenant le poly(benzo[C]thiophène)=poly (isothianaphtène), le polythiophène, poly (3-méthylthiophène), le poly(3-octylthiophène), la polyaniline, le poly(*p*-phénylène), le poly(thiophène)vinylène, le polyacétylène, le polyazulène, les diacéthylènes et les phtalocyanines dopés ou non dopés et d'un deuxième groupe comprenant le platine, le ruthénium, le rhodium, le palladium, l'iridium, l'osmium l'argent, l'or, le platine, l'aluminium, l'indium, le magnésium et les oxydes conducteurs des éléments des colonnes 8 à 10 de la classification périodique moderne.

40. Cellule selon la revendication 26, caractérisée en ce que la couche (26) de matériau isolant est réalisée en un matériau choisi parmi l'ensemble formé d'un premier groupe comprenant l'oxyde d'aluminium, l'oxyde de silicium, l'oxyde de zirconium, l'oxyde d'yttrium, l'oxyde de lanthane, le fluoro-oxyde d'aluminium, le nitrure de bore cubique, le diamant, d'un deuxième groupe comprenant des oxydes métalliques ayant une bande interdite supérieure à 3,5 eV, et d'un troisième groupe comprenant le polyimide, le polymétaméthylacrylate, polyéthylène, polypropylène, le polystyrène, et les polysilanes.

**Patentansprüche**

1. Photovoltaische Zelle (1), umfassend ein Substrat (2) mit einer Supportseite (4), auf der sich eine erste Elektrode (6) erstreckt, und eine zweite Elektrode (10), die von der ersten Elektrode (6) durch eine Mehrzahl von Schichten (14, 16; 14, 24, 16) getrennt ist, die mindestens eine erste Schicht (14) eines Halbleitermaterials umfaßt, an dessen Grenzfläche sich eine aktive Sperrschicht (J) befindet, die eine abgewickelte Oberfläche besitzt, die größer ist als ihre Projektionsfläche, dadurch gekennzeichnet, daß die erste Elektrode (6) eine gleichförmige Schicht (18), gebildet aus einem leitenden Material, und eine poröse Schicht umfaßt, gebildet aus kolloidalen leitenden Partikeln (20), die eine abgewickelte Oberfläche besitzt, die größer ist als ihre Projektionsfläche, und über der sich nacheinander die genannten Schichten (14, 16; 14, 24, 16) und die zweite Elektrode (10) erstrecken, und daß die erste Schicht (14) aus Halbleitermaterial eine Dicke aufweist, die kleiner oder gleich der Hälfte der Breite der Poren (22) der porösen Schicht ist.

2. Zelle nach Anspruch 1, dadurch gekennzeichnet, daß die aktive Sperrschicht (J) einen Rauhigkeitsfaktor in der Größenordnung von 2000 aufweist.

3. Zelle nach Anspruch 1 oder 2, dadurch gekennzeichnet, daß die kolloidalen leitenden Partikel (20) einen Durchmesser haben, der zwischen 1 und 200 Nanometern liegt.

4. Zelle nach einem der Ansprüche 1 bis 3, dadurch gekennzeichnet, daß die aus kolloidalen leitenden Partikeln (20) gebildete Schicht eine Dicke aufweist, die zwischen 0,1 und 20 Mikrometern liegt.

5. Zelle nach einem der vorangehenden Ansprüche, dadurch gekennzeichnet, daß die Mehrzahl von Schichten (14, 16; 14, 24, 16) neben der genannten ersten Schicht (14) aus Halbleitermaterial eine leitende Schicht (16) umfaßt, die sich zwischen der ersten Schicht (14) aus Halbleitermaterial und der zweiten Elektrode (10) erstreckt.

6. Zelle nach Anspruch 5, dadurch gekennzeichnet, daß die Mehrzahl von Schichten (14, 24, 16) ferner eine Schicht (24) aus isolierendem Material umfaßt, die sich zwischen der ersten Schicht (14) aus Halbleitermaterial und der leitenden Schicht (16) erstreckt.

7. Zelle nach Anspruch 5 oder 6, dadurch gekennzeichnet, daß die zweite Elektrode (10) von der leitenden Schicht gebildet ist.

8. Zelle nach einem der Ansprüche 1 bis 4, dadurch gekennzeichnet, daß die Mehrzahl von Schichten (14, 16; 14, 24, 16) neben der ersten Schicht (14) aus Halbleitermaterial eine zweite Schicht (16) aus Halbleitermaterial eines Leitfähigkeitstyps umfaßt, der unterschiedlich gegenüber dem der ersten Schicht (14) aus Halbleitermaterial ist, und die sich zwischen der ersten Schicht und der zweiten Elektrode (10) erstreckt.

9. Zelle nach Anspruch 8, dadurch gekennzeichnet, daß die Mehrzahl von Schichten (14, 16; 14, 24, 16) ferner eine Schicht (24) aus isolierendem Material umfaßt, die sich zwischen der ersten Schicht (14) aus Halbleitermaterial und der zweiten Schicht (16) aus Halbleitermaterial erstreckt.

10. Zelle nach einem der vorangehenden Ansprüche, dadurch gekennzeichnet, daß die erste Elektrode (6) aus einem Material hergestellt ist, gewählt aus der Gesamtheit, umfassend das mit Fluor, mit Antimon oder Arsen dotierte Zinnoxid, das Aluminiumstannat und das mit Aluminium dotierte Zinkoxid.

11. Zelle nach einem der Ansprüche 1 bis 10, dadurch gekennzeichnet, daß die erste Schicht (14) aus Halbleitermaterial aus einem anorganischen Halbleitermaterial hergestellt ist.

12. Zelle nach Anspruch 8 oder 9, dadurch gekennzeichnet, daß die erste Schicht (14) aus Halbleitermaterial und/oder die zweite Schicht aus Halbleitermaterial (16) aus einem anorganischen Halbleitermaterial hergestellt ist.

13. Zelle nach einem der Ansprüche 1 bis 10, dadurch gekennzeichnet, daß die erste Schicht (14) aus Halbleitermaterial aus einem organischen Halbleitermaterial hergestellt ist.

14. Zelle nach Anspruch 8 oder 9, dadurch gekennzeichnet, daß die erste Schicht (14) aus Halbleitermaterial und/oder die zweite Schicht aus Halbleitermaterial (16) aus einem organischen Halbleitermaterial hergestellt ist.

15. Zelle nach Anspruch 12, dadurch gekennzeichnet, daß die erste Schicht (14) aus Halbleitermaterial und/oder die zweite Schicht aus Halbleitermaterial (16) aus einem Halbleitermaterial hergestellt ist, ausgewählt aus der Gesamtheit von Halbleitermaterialien, gebildet aus einer ersten Gruppe, umfassend die halbleitenden Oxide der Übergangselemente, die halbleitenden Oxide der Elemente der Spalten 13 und 14 des modernen Periodensystems und die halbleitenden Oxide der Lanthanide, einer zweiten Gruppe, umfassend die halbleitenden Mischoxide, gebildet aus einem Gemisch von zwei oder mehr Oxiden der ersten Gruppe, einer dritten Gruppe, umfassend die halbleitenden Mischoxide, gebildet aus einem Gemisch von einem oder mehreren Oxiden der ersten Gruppe mit Oxiden der Elemente der Spalten 1 und 2 des modernen Periodensystems, und einer vierten Gruppe, umfassend Silizium, Siliziumhydrid, Siliziumkarbid, Germanium, Kadmiumsulfid, Kadmiumtellurid, Zinksulfid, Bleisulfid, Eisensulfid, Zinkselenid, Galliumarsenid, Indiumphosphid, Galliumphosphid, Kadmiumphosphid, Titanfluorid, Titannitrid, Zirkoniumfluorid, Zirkoniumnitrid, dotierten Diamant, Kupferthiozyanat und reine und gemischte Chalcopyrite.

16. Zelle nach Anspruch 15, dadurch gekennzeichnet, daß das Halbleitermaterial unter einer Gesamtheit von Materialien gewählt ist, umfassend das Titanoxid, Lanthaniumoxid, Zirkoniumoxid, Niobiumoxid, Wolfframoxid, Strontiumoxid, Kalzium-/Titanoxid, Natriumtitanat und Kaliumniobat.

17. Zelle nach Anspruch 14, dadurch gekennzeichnet, daß die erste Schicht (14) aus Halbleitermaterial und/oder die zweite Schicht aus Halbleitermaterial (16) aus einem Halbleitermaterial hergestellt ist, gewählt unter der Gesamtheit von dotierten und/oder nicht dotierten Halbleitermaterialien, umfassend die Phtalocyanine, das 2,9-dimethylquinakridon, das 1,1-bis(4-di-**p**-tolylaminophenyl)-cyclohexan, das Phtalocyaninbisnaphtalocyanin, das Poly(N-vinylkarbazol), die Polyantrazene, die Polyphenole, die Polysilane, die Poly(**p**-phenylen)vinylene, die Porphyrine, das Perylen und seine Derivate, das Poly(benzo[C]thiophen)=poly(isothianaphten), das Polythiophen, Poly(3-methylthiophen), das Poly(3-oktylthiophen), das Polyanilin, das Poly(**p**-phenylen), das Poly(thiophen)vinylen, das Polyacetylen, das Polyazulen, die Diacethylene.

18. Zelle nach Anspruch 14, dadurch gekennzeichnet, daß die erste Schicht (14) aus Halbleitermaterial und/oder die zweite Schicht aus Halbleitermaterial (16) aus einem Halbleitermaterial hergestellt ist, gewählt unter der Gesamtheit von halbleitenden Materialien, umfassend das $H_2Pc$, das MgPc dotiert mit $O_2$, das CuPc, das ZnPc, das FePc, das SiPc, das NiPc, das Al(Cl)Pc, das Al(0H)Pc, das $LuPc_2$ dotiert mit Dichlorocyanoquinon, das Dichlorid des Tetra-4-ter-butylphtalocyaninosilizium, das LuPc2: 2,2' 6,6'-tetraphenyl 4,4'-(**p**-dimethylaminostyryl)-4H-pyran und das 5,10,15,20-tetra(3-pyridyl)porphyrin, das LuPc und das $NiPc:I_2$, wobei die Abkürzung Pc Phtalocyanin bedeutet.

19. Zelle nach Anspruch 5, dadurch gekennzeichnet, daß die leitende Schicht (16) aus einem Material hergestellt ist, gewählt aus der Gesamtheit, gebildet aus einer ersten Gruppe, umfassend das Poly(benzo[C]thiophen)=poly(isothianaphten), dem Polythiophen, Poly(3-methylthiophen), dem Poly(3-octylthiophen), dem Polyanilin, dem Poly(**p**-phenylen), dem Poly(thiophen)vinylen, dem Polyacetylen, dem Polyazulen, den Diacethylenen und den Phtalocyaninen, dotiert oder nicht dotiert, und einer zweiten Gruppe, umfassend das Platin, das Ruthenium, das Rhodium, das Palladium, das Iridium, das Osmium, das Silber, das Gold, das Aluminium, das Indium, das Magnesium und die leitenden Oxide der Elemente der Spalten 8 bis 10 des modernen Periodensystems.

20. Zelle nach Anspruch 6, dadurch gekennzeichnet, daß die Schicht (26) aus isolierendem Material aus einem Material hergestellt ist, gewählt unter der Gesamtheit, gebildet aus einer ersten Gruppe, umfassend das Aluminiumoxid, das Siliziumoxid, das Zirkonoxid, das Yttriumoxid, das Lanthanoxid, das Aluminiumfluoro-oxid, das kubische Bohrnitrid, den Diamant, und aus einer zweiten Gruppe, umfassend die metallischen Oxide mit einem verbotenen Band oberhalb 3,5 eV, und einer dritten Gruppe, umfassend die Polyimide, die Polymetamethylacrylate, Polyethylen, Polypropylen, das Polystyren und die Polysilane.

21. Photovoltaische Zelle (1), umfassend ein Substrat (2), umfassend eine Supportseite (4), auf der sich eine erste Elektrode (6) erstreckt, und eine zweite Elektrode (10), die von der ersten Elektrode (6) durch eine Mehrzahl von Schichten (14, 16; 14, 24, 16) getrennt ist, umfassend mindestens eine erste Schicht (14) eines Halbleitermaterials mit einer Grenzschicht, an der sich eine aktive Sperrschicht (J) befindet, welche eine abgewickelte Oberfläche besitzt, die größer ist als seine Projektionsfläche, dadurch gekennzeichnet, daß die erste Schicht (14) aus Halbleitermaterial eine poröse Schicht umfaßt, gebildet aus kolloidalen Partikeln (20), welche eine abgewickelte Oberfläche größer als ihre Projektionsfläche aufweist, und eine gleichförmige Schicht, welche die poröse Schicht abdeckt, auf welcher sich nacheinander die anderen Schichten (16; 24, 16) und die zweite Elektrode (10) erstrecken, und daß die kolloidalen Partikel (20) einen Durchmesser kleiner als die Diffusionslänge der Minoritätsträger aufweisen, erzeugt durch Lichtabsorption in der porösen Schicht.

22. Zelle nach Anspruch 21, dadurch gekennzeichnet, daß die aktive Sperrschicht (J) einen Rauhigkeitsfaktor in der Größenordnung von 2000 aufweist.

23. Zelle nach Anspruch 21 oder 22, dadurch gekennzeichnet, daß die kolloidalen Partikel einen Durchmesser haben, der zwischen 1 und 200 Nanometern liegt.

24. Zelle nach einem der Ansprüche 21 bis 23, dadurch gekennzeichnet, daß die aus kolloidalen Partikeln (20) gebildete Schicht eine Dicke aufweist, die zwischen 0,1 und 20 Mikrometern liegt.

25. Zelle nach einem der Ansprüche 21 bis 24, dadurch gekennzeichnet, daß die Mehrzahl von Schichten (14, 16; 14, 24, 16) neben der genannten ersten Schicht (14) aus Halbleitermaterial eine leitende Schicht (16) umfaßt, die sich zwischen der ersten Schicht (14) aus Halbleitermaterial und der zweiten Elektrode (10) erstreckt.

26. Zelle nach Anspruch 25, dadurch gekennzeichnet, daß die Mehrzahl von Schichten (14, 24, 16) ferner eine Schicht (24) aus isolierendem Material umfaßt, die sich zwischen der ersten Schicht (14) aus Halbleitermaterial und der leitenden Schicht erstreckt.

27. Zelle nach Anspruch 25 oder 26, dadurch gekennzeichnet, daß die zweite Elektrode (10) von der leitenden Schicht gebildet ist.

28. Zelle nach einem der Ansprüche 21 bis 24, dadurch gekennzeichnet, daß die Mehrzahl von Schichten (14, 16; 14, 24, 16) neben der ersten Schicht (14) aus Halbleitermaterial eine zweite Schicht (16) aus Halbleitermaterial eines Leitfähigkeitstyps umfaßt, der unterschiedlich gegenüber dem der ersten Schicht (14) aus Halbleitermaterial ist, und die sich zwischen der ersten Schicht und der zweiten Elektrode (10) erstreckt.

29. Zelle nach Anspruch 28, dadurch gekennzeichnet, daß die Mehrzahl von Schichten (14, 16; 14, 24, 16) ferner eine Schicht (24) aus isolierendem Material umfaßt, die sich zwischen der ersten Schicht (14) aus Halbleitermaterial und der zweiten Schicht (16) aus Halbleitermaterial erstreckt.

30. Zelle nach einem der Ansprüche 21 bis 29, dadurch gekennzeichnet, daß die erste Elektrode (6) aus einem Material hergestellt ist, gewählt aus der Gesamtheit, umfassend das mit Fluor, mit Antimon oder Arsen dotierte Zinnoxid, das Aluminiumstannat und das mit Aluminium dotierte Zinkoxid.

31. Zelle nach einem der Ansprüche 21 bis 30, dadurch gekennzeichnet, daß die erste Schicht (14) aus Halbleitermaterial aus einem anorganischen Halbleitermaterial hergestellt ist.

32. Zelle nach Anspruch 28 oder 29, dadurch gekennzeichnet, daß die erste Schicht (14) aus Halbleitermaterial und/oder die zweite Schicht aus Halbleitermaterial (16) aus einem anorganischen Halbleitermaterial hergestellt ist.

33. Zelle nach einem der Ansprüche 21 bis 30, dadurch gekennzeichnet, daß die erste Schicht (14) aus Halbleitermaterial aus einem organischen Halbleitermaterial hergestellt ist.

**34.** Zelle nach Anspruch 28 oder 29, dadurch gekennzeichnet, daß die erste Schicht (14) aus Halbleitermaterial und/oder die zweite Schicht aus Halbleitermaterial (16) aus einem organischen Halbleitermaterial hergestellt ist.

**35.** Zelle nach Anspruch 32, dadurch gekennzeichnet, daß die erste Schicht (14) aus Halbleitermaterial und/oder die zweite Schicht aus Halbleitermaterial (16) aus einem Halbleitermaterial hergestellt ist, ausgewählt aus der Gesamtheit von Halbleitermaterialien, gebildet aus einer ersten Gruppe, umfassend die halbleitenden Oxide der Übergangselemente, die halbleitenden Oxide der Elemente der Spalten 13 und 14 des modernen Periodensystems und die halbleitenden Oxide der Lanthanide, einer zweiten Gruppe, umfassend die halbleitenden Mischoxide, gebildet aus einem Gemisch von zwei oder mehr Oxiden der ersten Gruppe, einer dritten Gruppe, umfassend die halbleitenden Mischoxide, gebildet aus einem Gemisch von einem oder mehreren Oxiden der ersten Gruppe mit Oxiden der Elemente der Spalten 1 und 2 des modernen Periodensystems, und einer vierten Gruppe, umfassend Silizium, Siliziumhydrid, Siliziumkarbid, Germanium, Kadmiumsulfid, Kadmiumtellurid, Zinksulfid, Bleisulfid, Eisensulfid, Zinkselenid, Galliumarsenid, Indiumphosphid, Galliumphosphid, Kadmiumphosphid, Titanfluorid, Titannitrid, Zirkoniumfluorid, Zirkoniumnitrid, dotierten Diamant, Kupferthiozyanat und reine und gemischte Chalcopyrite.

**36.** Zelle nach Anspruch 35, dadurch gekennzeichnet, daß das Halbleitermaterial unter einer Gesamtheit von Materialien gewählt ist, umfassend das Titanoxid, Lanthaniumoxid, Zirkoniumoxid, Niobiumoxid, Wolfframoxid, Strontiumoxid, Kalzium-/Titanoxid, Natriumtitanat und Kaliumniobat.

**37.** Zelle nach Anspruch 34, dadurch gekennzeichnet, daß die erste Schicht (14) aus Halbleitermaterial und/oder die zweite Schicht aus Halbleitermaterial (16) aus einem Halbleitermaterial hergestellt ist, gewählt unter der Gesamtheit von dotierten und/oder nicht dotierten Halbleitermaterialien, umfassend die Phtalocyanine, das 2,9-dimethylquinakridon, das 1,1-bis(4-di-**p**-tolylaminophenyl)-cyclohexan, das Phtalocyaninbisnaphtalocyanin, das Poly(N-vinylkarbazol), die Polyantrazene, die Polyphenole, die Polysilane, die Poly(**p**-phenylen)vinylene, die Porphyrine, das Perylen und seine Derivate, das Poly(benzo[**C**]thiophen)=poly(isothianaphten), das Polythiophen, Poly(3-methylthiophen), das Poly(3-octylthiophen), das Polyanilin, das Poly(**p**-phenylen), das Poly(thiophen)vinylen, das Polyacetylen, das Polyazulen, die Diacethylene.

**38.** Zelle nach Anspruch 34, dadurch gekennzeichnet, daß die erste Schicht (14) aus Halbleitermaterial und/oder die zweite Schicht aus Halbleitermaterial (16) aus einem Halbleitermaterial hergestellt ist, gewählt unter der Gesamtheit von halbleitenden Materialien, umfassend das $H_2Pc$, das MgPc dotiert mit $O_2$, das CuPc, das ZnPc, das FePc, das SiPc, das NiPc, das Al(Cl)Pc, das Al(OH)Pc, das $LuPc_2$ dotiert mit Dichlorocyanoquinon, das Dichlorid des Tetra-4-ter-butylphtalocyaninosilizium, das LuPc2: 2,2' 6,6'-tetraphenyl 4,4'-(**p**-dimethylaminostyryl)-4H-pyran und das 5,10,15,20-tetra(3-pyridyl)porphyrin, das LuPc und das $NiPc:I_2$, wobei die Abkürzung Pc Phtalocyanin bedeutet.

**39.** Zelle nach Anspruch 25, dadurch gekennzeichnet, daß die leitende Schicht (16) aus einem Material hergestellt ist, gewählt aus der Gesamtheit, gebildet aus einer ersten Gruppe, umfassend das Poly(benzo[C]thiophen)=poly(isothianaphten), dem Polythiophen, Poly(3-methylthiophen), dem Poly(3-octylthiophen), dem Polyanilin, dem Poly(**p**-phenylen), dem Poly(thiophen)vinylen, dem Polyacetylen, dem Polyazulen, den Diacethylenen und den Phtalocyaninen, dotiert oder nicht dotiert, und einer zweiten Gruppe, umfassend das Platin, das Ruthenium, das Rhodium, das Palladium, das Iridium, das Osmium, das Silber, das Gold, das Aluminium, das Indium, das Magnesium und die leitenden Oxide der Elemente der Spalten 8 bis 10 des modernen Periodensystems.

**40.** Zelle nach Anspruch 26, dadurch gekennzeichnet, daß die Schicht (26) aus isolierendem Material aus einem Material hergestellt ist, gewählt unter der Gesamtheit, gebildet aus einer ersten Gruppe, umfassend das Aluminiumoxid, das Siliziumoxid, das Zirkonoxid, das Yttriumoxid, das Lanthanoxid, das Aluminiumfluoro-oxid, das kubische Bohrnitrid, den Diamant, und aus einer zweiten Gruppe, umfassend die metallischen Oxide mit einem verbotenen Band oberhalb 3,5 eV, und einer dritten Gruppe, umfassend die Polyimide, die Polymetamethylacrylate, Polyethylen, Polypropylen, das Polystyren und die Polysilane.

**Claims**

**1.** Photovoltaic cell (1) comprising a substrate (2) having a support face (4) having disposed thereon a first electrode (6), and a second electrode (10) separated from the first electrode (6) by a plurality of layers (14, 16; 14, 24, 16) comprising at least a first layer (14) of a semiconducting material with an active junction (J) at an interface thereof which has a developed surface area greater than its projected surface, characterized in that said first electrode (6) comprises a uniform layer (18) formed of a conducting material and a porous layer formed of conducting colloidal particles (20), which has a developed surface area greater than its projected surface area and on which said layers (14, 16; 14, 24, 16) and said second electrode (10) are disposed successively, and in that said first layer (14) of semiconducting material has a thickness lower than or equal to the half of the width of the pores (22) of said porous layer.

2. Cell according to claim 1, characterized in that said active junction (J) exhibits a roughness factor of the order of 2000.

3. Cell according to claim 1 or 2, characterized in that said conducting colloidal particles (20) have a diameter between 1 and 200 nanometers.

4. Cell according to any one of claims 1 to 3, characterized in that said layer formed of conducting colloidal particles (20) has a thickness between 0.1 and 20 micrometers.

5. Cell according to any one of the preceding claims, characterized in that said plurality of layers (14, 16; 14, 24, 16) comprises, apart from said first layer (14) of semiconducting material, a conducting layer (16) which extends between said first layer (14) of semiconducting material and said second electrode (10).

6. Cell according to claim 5, characterized in that said plurality of layers (14, 24, 16) also comprises a layer (24) of insulating material extending between said first layer (14) of semiconducting material and said conducting layer (16).

7. Cell according to claim 5 or 6, characterized in that said second electrode (10) is formed by said conducting layer.

8. Cell according to any one of claims 1 to 4, characterized in that said plurality of layers (14, 16; 14, 24, 16) comprises, apart from said first layer (14) of semiconducting material, a second layer (16) of semiconducting material of a different type of conductivity from that of the first layer (14) of semiconducting material and which extends between said first layer and the second electrode (10).

9. Cell according to claim 8, characterized in that said plurality of layers (14, 16; 14, 24, 16) also comprises a layer (24) of insulating material extending between said first layer (14) of semiconducting material and said second layer (16) of semiconducting material.

10. Cell according to any one of the preceding claims, characterized in that the first electrode (6) is made of a material chosen from the group comprising tin oxide doped with fluorine, antimony or arsenic, aluminium stannate, and zinc oxide doped with aluminium.

11. Cell according to any one of claims 1 to 10, characterized in that said first layer (14) of semiconducting material is made of an inorganic semiconducting material.

12. Cell according to claim 8 or 9, characterized in that said first layer (14) of semiconducting material and/ or said second layer of semiconducting material (16) are made of an inorganic semiconducting material.

13. Cell according to any one of claims 1 to 10, characterized in that said first layer (14) of semiconducting material is made of an organic semiconducting material.

14. Cell according to claim 8 or 9, characterized in that said first layer (14) of semiconducting material and/ or said second layer of semiconducting material (16) are made of an organic semiconducting material.

15. Cell according to claim 12, characterized in that said first layer (14) of semiconducting and/or said second layer of semiconducting material (16) are made of a semiconducting material selected from the group of semiconducting materials formed of a first group comprising semiconducting oxides of the transition elements, semiconducting oxides of the elements of columns 13 and 14 of the modern periodic classification and semiconducting lanthanide oxides, of a second group comprising mixed semiconducting oxides formed of a mixture of two or several oxides of the first group, of a third group comprising mixed semiconducting oxides formed of a mixture of one or several oxides of the first group with oxides of the elements of columns 1 and 2 of the modern periodic classification and of a fourth group comprising silicon, silicon hydride, silicon carbide, germanium, cadmium sulphide, cadmium telluride, zinc sulphide, lead sulphide, iron sulphide, zinc selenide, gallium arsenide, indium phosphide, gallium phosphide, cadmium phosphide, titanium fluoride, titan nitride, zirconium fluoride, zirconium nitride, doped diamond, copper thiocyanate and pure and mixed chalcopyrites.

16. Cell according to claim 15, characterized in that the semiconducting material is selected from the group of materials comprising titanium oxide, lanthanium oxide, zirconium oxide, niobium oxide, tungsten oxide, strontium oxide, calcium/titanium oxide, sodium titanate and potassium niobiate.

17. Cell according to claim 14, characterized in that said first layer (14) of semiconducting material and/or said second layer of semiconducting material (16) are made of a semiconducting material selected from the group of doped and/or undoped semiconducting materials comprising the phthalocyanines, 2,9-dimethyl quinacridone, 1,1-bis(4-di-p-tolylaminophenyl) cyclohexane, phthalocyanine bisnaphthalocyanine, poly(N-vinylcarbazole), polyanthracenes, polyphenols, polysilanes, poly(p-phenylene)vinylene, porphyrines, perylene and its derivatives, poly(benzo[C] thiophene)= poly(isothianaphthene), polythiophene, poly(3-methylthiophene), poly(3-octylthiophene), polyaniline, poly (p-phenylene), poly(thiophene)vinylene, polyacetylene, polyazulene and diacetylenes.

18. Cell according to claim 14, characterized in that said first layer (14) of semiconducting material and/or said second layer of semiconducting material (16) are made of a semiconducting material selected from the group of semiconducting materials comprising $H_2Pc$, MgPc doped with $O_2$, CuPc, ZnPc, FePc, SiPc, NiPc, Al(Cl)Pc, Al(OH)Pc, $LuPc_2$ doped with dichlorocyanoquinone, tetra-4-ter-butylphthalocyaninosilicon dichloride, LuPc:2,2' 6,6'-tetraphenyl-4,4'(p-dimethylaminostyryl)4H-pyrane and 5,10,15, 20-tetra(3-pyridyl)porphyrine, LuPc and $NiPc:I_2$, the shortening Pc meaning phthalocyanine.

19. Cell according to claim 5, characterized in that the conducting layer (16) is made of a material selected from the group formed of a first group comprising poly(benzo[C]thiophene)= poly(isothianaphthene), polythiophene, poly(3-methylthiophene), poly (3-octyl-thiophene), polyaniline, poly(p-phenylene), poly(thiophene)vinylene, polyacetylene, polyazulene, diacetylenes, and doped or undoped phthalocyanines and of a second group comprising platinum, ruthenium, rhodium, palladium, iridium, osmium, silver, gold, platinum, aluminium, indium, magnesium and conducting oxides of the elements of columns 8 to 10 of the modern periodic classification.

20. Cell according to claim 6, characterized in that the layer (26) of insulating material is made of a material selected from the group formed of a first group comprising aluminium oxide, silicon oxide, zirconium oxide, yttrium oxide, lanthanum oxide, aluminium oxyfluoride, cubic boron nitride, diamond, of a second group comprising metal oxides having a forbidden band greater than 3.5 eV and of a third group comprising polyimide, polymetamethylacrylate, polyethylene, polypropylene, polystyrene and polysilanes.

21. Photovoltaic cell (1) comprising a substrate (2) having a support face (4) having disposed thereon a first electrode (6), and a second electrode (10) separated from the first electrode (6) by a plurality of layers (14, 16; 14, 24, 16) comprising at least a first layer (14) of a semiconducting material with one active junction (J) at an interface thereof which has a developed surface area greater than its projected surface area, characterized in that said first layer (14) of semiconducting material comprises a porous layer formed of colloidal particles (20) which has a developed surface area greater than its projected surface area and a uniform layer covering said porous layer, on which said other layers (16; 24, 16) and said second electrode (10) are disposed successively, and in that said colloidal particles (20) have a diameter lower than the diffusion length of minority charge carriers created in said porous layer by the absorption of light.

22. Cell according to claim 21, characterized in that said active junction (J) exhibits a roughness factor of the order of 2000.

23. Cell according to claim 21 or 22, characterized in that said colloidal particles (20) have a diameter between 1 and 200 nanometers.

24. Cell according to any one of claims 21 to 23, characterized in that said layer formed of colloidal particles (20) has a thickness between 0.1 and 20 micrometers.

25. Cell according to any one of claims 21 to 24, characterized in that said plurality of layers (14, 16; 14, 24, 16) comprises, apart from said first layer (14) of semiconducting material, a conducting layer (16) which extends between said first layer (14) of semiconducting material and said second electrode (10).

26. Cell according to claim 25, characterized in that said plurality of layers (14, 24, 16) also comprises a layer (24) of insulating material extending between said first layer (14) of semiconducting material and said conducting layer (16).

27. Cell according to claim 25 or 26, characterized in that said second electrode (10) is formed by said conducting layer.

28. Cell according to any one of claims 21 to 24, characterized in that said plurality of layers (14, 16; 14, 24, 16) comprises, apart from said first layer (14) of semiconducting material, a second layer (16) of semiconducting material of a different type of conductivity from that of the first layer (14) of semiconducting material and which extends between said first layer and the second electrode (10).

29. Cell according to claim 28, characterized in that said plurality of layers (14, 16; 14, 24, 16) also comprises a layer (24) of insulating material extending between said first layer (14) of semiconducting material and said second layer (16) of semiconducting material.

30. Cell according to any one of claims 21 to 29, characterized in that the first electrode (6) is made of a material chosen from the group comprising tin oxide doped with fluorine, antimony or arsenic, aluminium stannate, and zinc oxide doped with aluminium.

31. Cell according to any one of claims 21 to 30, characterized in that said first layer (14) of semiconducting material is made of an inorganic semiconducting material.

32. Cell according to claim 28 or 29, characterized in that said first layer (14) of semiconducting material and/or said second layer of semiconducting material (16) are made of an inorganic semiconducting material.

33. Cell according to any one of claims 21 to 30, characterized in that said first layer (14) of semiconducting material is made of an organic semiconducting material.

34. Cell according to claim 28 or 29, characterized in that said first layer (14) of semiconducting material and/or said second layer of semiconducting material (16) are made of an organic semiconducting material.

35. Cell according to claim 32, characterized in that said first layer (14) of semiconducting and/or said second layer of semiconducting material (16) are made of a semiconducting material selected from the group of semiconducting materials formed of a first group comprising semiconducting oxides of the transition elements, semiconducting oxides of the elements of columns 13 and 14 of the modern periodic classification and semiconducting lanthanide oxides, of a second group comprising mixed semiconducting oxides formed of a mixture of two or several oxides of the first group, of a third group comprising mixed semiconducting oxides formed of a mixture of one or several oxides of the first group with oxides of the elements of columns 1 and 2 of the modern periodic classification and of a fourth group comprising silicon, silicon hydride, silicon carbide, germanium, cadmium sulphide, cadmium telluride, zinc sulphide, lead sulphide, iron sulphide, zinc selenide, gallium arsenide, indium phosphide, gallium phosphide, cadmium phosphide, titanium fluoride, titan nitride, zirconium fluoride, zirconium nitride, doped diamond, copper thiocyanate and pure and mixed chalcopyrites.

36. Cell according to claim 35, characterized in that the semiconducting material is selected from the group of materials comprising titanium oxide, lanthanium oxide, zirconium oxide, niobium oxide, tungsten oxide, strontium oxide, calcium/titanium oxide, sodium titanate and potassium niobiate.

37. Cell according to claim 34, characterized in that said first layer (14) of semiconducting material and/or said second layer of semiconducting material (16) are made of a semiconducting material selected from the group of doped and/or undoped semiconducting materials comprising the phthalocyanines, 2,9-dimethyl quinacridone, 1,1-bis(4-di-p-tolylaminophenyl) cyclohexane, phthalocyanine bisnaphthalocyanine, poly(N-vinylcarbazole), polyanthracenes, polyphenols, polysilanes, poly(p-phenylene)vinylene, porphyrines, perylene and its derivatives, poly(benzo[C] thiophene)= poly(isothianaphthene), polythiophene, poly(3-methylthiophene), poly(3-octylthiophene), polyaniline, poly(p-phenylene), poly(thiophene)vinylene, polyacetylene, polyazulene and diacetylenes.

38. Cell according to claim 34, characterized in that said first layer (14) of semiconducting material and/or said second layer of semiconducting material (16) are made of a semiconducting material selected from the group of semiconducting materials comprising $H_2Pc$, MgPc doped with $O_2$, CuPc, ZnPc, FePc, SiPc, NiPc, Al(Cl)Pc, Al(OH)Pc, $LuPc_2$ doped with dichlorocyanoquinone, tetra-4-ter-butylphthalocyaninosilicon dichloride, LuPc:2,2' 6,6'-tetraphenyl-4,4'(p-dimethylaminostyryl)4H-pyrane and 5,10,15, 20-tetra(3-pyridyl)porphyrine, LuPc and $NiPc:I_2$, the shortening Pc meaning phthalocyanine.

39. Cell according to claim 25, characterized in that the conducting layer (16) is made of a material selected from the group formed of a first group comprising poly(benzo[C]thiophene)= poly(isothianaphthene), polythiophene, poly(3-methylthiophene), poly(3-octyl-thiophene), polyaniline, poly(p-phenylene), poly(thiophene)vinylene, polyacetylene, polyazulene, diacetylenes, and doped or undoped phthalocyanines and of a second group comprising platinum, ruthenium, rhodium, palladium, iridium, osmium, silver, gold, platinum, aluminium, indium, magnesium and conducting oxides of the elements of columns 8 to 10 of the modern periodic classification.

**40.** Cell according to claim 26, characterized in that the layer (26) of insulating material is made of a material selected from the group formed of a first group comprising aluminium oxide, silicon oxide, zirconium oxide, yttrium oxide, lanthanum oxide, aluminium oxyfluoride, cubic boron nitride, diamond, of a second group comprising metal oxides having a forbidden band greater than 3.5 eV and of a third group comprising polyimide, polymetamethylacrylate, polyethylene, polypropylene, polystyrene and polysilanes.

Fig. 1

Fig. 2

Fig. 3

Fig. 4

Fig. 5

EP 0 606 453 B1

Fig. 6

10
16
14
20
6
2

Fig. 7

12
8
10
4
6

VIII, IX, X, XI, XII

Fig. 8

10
16
24
14
6
2

Fig. 9

10
16
24
14
6
2

Fig. 10

10
16
24
14
6
2

18

Fig. 11

Fig. 12